# EUROPEAN PATENT SPECIFICATION

(11) **EP 0 700 242 B1**
(45) Date of publication and mention of the grant of the patent: **09.04.1997**
(21) Application number: 95201958.6
(22) Date of filing: 15.07.1995
(51) Int. Cl.: H05K 5/00, G05D 23/19

(54) **A device for regulating the temperature, in particular of domestic surroundings**
Temperaturregelvorrichtung speziell für häusliche Umgebung
Dispositif de régulation de température notamment pour endroits domestiques

(30) Priority: 05.09.1994 IT PD940155
(43) Date of publication of application: 06.03.1996
(73) Proprietor: BPT S.p.A., 30020 Cinto Caomaggiore (Venezia) (IT)
(72) Inventor: Vit, Luigi, 30020 Cinto Caomaggiore (Venezia) (IT)
(74) Representative: Cantaluppi, Stefano

(56) References cited:
- EP-A- 0 434 926
- EP-A- 0 575 214
- DE-U- 8 710 985
- FR-A- 2 607 998
- US-A- 4 295 180
- US-A- 5 107 918

## Description

The present invention relates to a device for regulating the temperature, in particular of domestic surroundings, of the type comprising a body which is removably inserted in a box-shaped element, at least one keyboard which is used for programming the device and is mounted on the body, and means for holding the body in the box-shaped element in a removable manner.

Devices of the type indicated are used for regulating the temperature of domestic and industrial surroundings. They are also known as time thermostats and can be programmed to regulate the temperature of the surroundings controlled in accordance with a selected pattern over time.

In the form designed for recessed mounting, these time thermostats comprise a body which contains the control circuit part of the device and which is removably inserted and advantageously held in a box-shaped element which is in its turn mounted in a conventional casing recessed in a wall.

Typically, time thermostats of this type have a body which can be completely removed from the box-shaped element in order to enable the batteries for the electrical supply of the circuit part of the device to be replaced.

A front wall of the body which constitutes a visible surface of the same generally accommodates a display indicating the temperature and the other operating parameters, as well as a keyboard for programming the device.

The keyboard generally comprises different types or key, some for more frequent programming, for example, of the temperature level set, and some for less frequent use, for example, for the specific programming of the time thermostat.

The space requirements of such devices restrict the space available on the front wall of the body for positioning the display and the programming keys. The requirement for adequate accessibility to the programming keys conflicts with that of an expedient display of the parameters set.

The time thermostats according to the prior art are normally produced by reaching a compromise between the mentioned requirements, which is to the detriment of either the dimensions of the display or the space intended for the programming keys.

The problem of the present invention is to provide a device having a structure and design such that it is possible to overcome the disadvantages discussed with reference to the mentioned prior art.

The problem is solved by the invention by means of a device of the type indicated which is characterised in that the keyboard is mounted on a portion of the body which constitutes a surface which is not in view when the body is in the position in which it is completely inserted in the box-shaped element and which is accessible when the body is partially removed from the box-shaped element.

The characteristics and advantages of the invention will be better appreciated from the following detailed description of a preferred embodiment illustrated by way of non-limiting example with reference to the appended drawings, in which:
- Figure 1 is a perspective view, partly in section and partly cutaway, of a device produced in accordance with the present invention;
- Figure 2 is a partially sectional perspective view of a detail of Figure 1; and
- Figures 3 and 4 are partially sectional perspective views of the same detail of Figure 2 in two different operating positions.

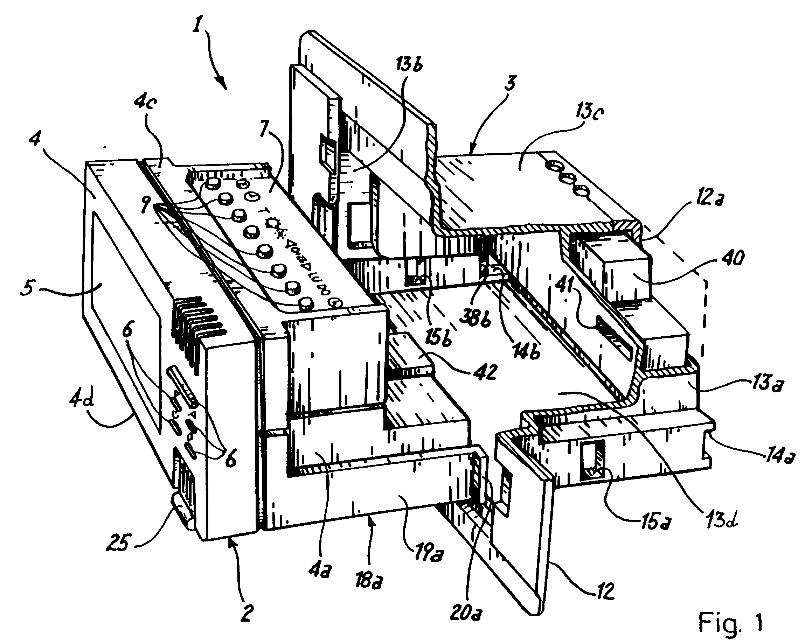

In Figure 1, a device for regulating the temperature, which is otherwise known as a time thermostat, is generally indicated 1. The device comprises a body 2 for accommodating the control circuit part of the device 1 and a box-shaped element 3 which is to be mounted in a conventional casing recessed in the wall (not shown).

The body 2 is substantially parallelepipedal with a front wall 4 forming a surface which is in view when the body 2 is in the position in which it is completely inserted in the box-shaped element 3, and side walls 4a, b, c, d which, in the same position, are in contrast partially or completely hidden inside the box-shaped element 3.

Extending along each of the opposing walls 4a, b is a respective retaining member 18a, b which comprises a resilient rod-shaped element 19a, b which is joined at one of its ends to the body 2 and carries at the opposite, free end a tooth 20a, b which projects at right angles.

Mounted on the wall 4 are a display 5, preferably a liquid-crystal display, and a series of keys all of which are indicated 6 and constitute a first keyboard for programming the device 1 for more frequent use, for example in respect of the temperature level provided for the surroundings controlled thereby.

Extending inside the body 2 and protected by the wall 4 is a duct 27 of which one end communicates with the outside by way of a grille 31 provided on the wall 4. The duct 27 is provided for the ventilation of a sensor 30 for measuring the ambient temperature.

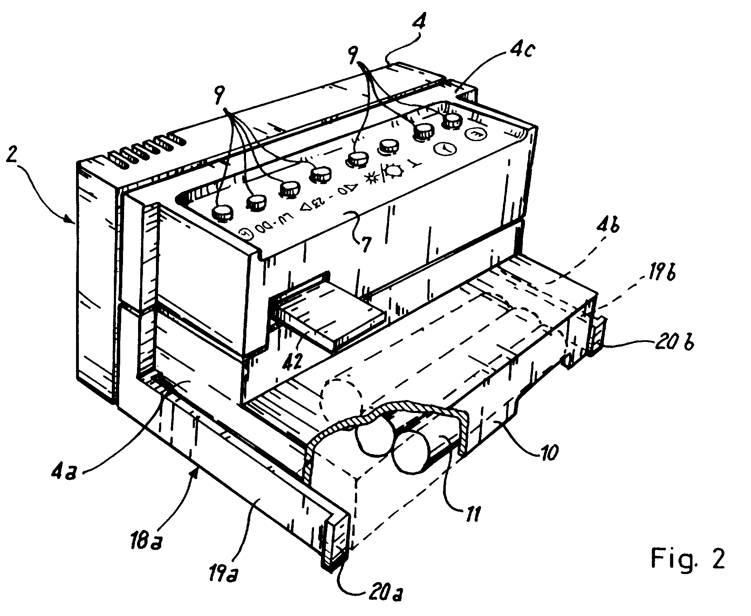

A compartment 10 (Figure 2) is provided in the body 2 in a position opposite the front wall 4 and is arranged to house batteries 11 for the electrical supply of the control circuit part of the device 1.

Indicated on the side wall 4c is a portion 7 carrying a further series of keys all of which are indicated 9 and form a second keyboard for programming the device for less frequent use, for example for the specific programming of the device 1. According to a preferred embodiment, the portion 7 of the wall 4c is sunken with respect to said wall in order to accommodate the keys 9 within the space occupied by the body 2, thus allowing the body to slide inside the box-shaped element 3.

The box-shaped element 3 (Figure 1) comprises side walls 13a, b, c, d extending between a frame 12 and a rear part 12a, in correspondence with which is arranged equipment which is generally indicated 40 and constitutes the power circuit part of the device 1.

A female connector 41 arranged in correspondence with the equipment 40 is releasably engaged by a male connector indicated 42 which extends outside the body 2, enabling the power circuit part associated with the box-shaped element 3 to be connected electrically in releasable manner to the control circuit part associated with the body 2.

Arranged along each of the opposing side walls 13a, b are two respective seats 14a, b and 15a, b which have a substantially rectangular opening and are engaged by the corresponding tooth 20a, b in a manner which will be explained hereinafter. According to a preferred embodiment, the seats 14a, b are arranged in correspondence with the rear part 12a and have all inclined surface 38a, b.

The body 2 is removably inserted in the box-shaped element 3 and is held in a completely inserted position when the teeth 20a, b are engaged in the seats 14a, b, respectively. The inclined surface 38a, b enables the tooth 20a, b to be disengaged from the corresponding seat when stress has been applied to the body 2 in order to remove it.

The body 2 can be withdrawn from a completely inserted position inside the box-shaped element 3 until the teeth 20a, b engage in the respective seats 15a, b. The seats 15a, b are arranged at a distance from the corresponding seats 14a, b and in a position such that, when they are engaged by the teeth 20a, b, the body 2 is held securely in a partially removed position with respect to the box-shaped element 3 in order to permit access to the programming keys 9.

Owing to the nature of the right-angled profile of the tooth 20a, b and the shape of the seat 15a, b, the body 2 can be disengaged from the partially removed position merely by deforming the rod-shaped member 19a, b resiliently in order to move the tooth 20a, b away from the corresponding seat and to permit the subsequent removal of the body 2 from the box-shaped element 3, for example in order to replace the batteries 11.

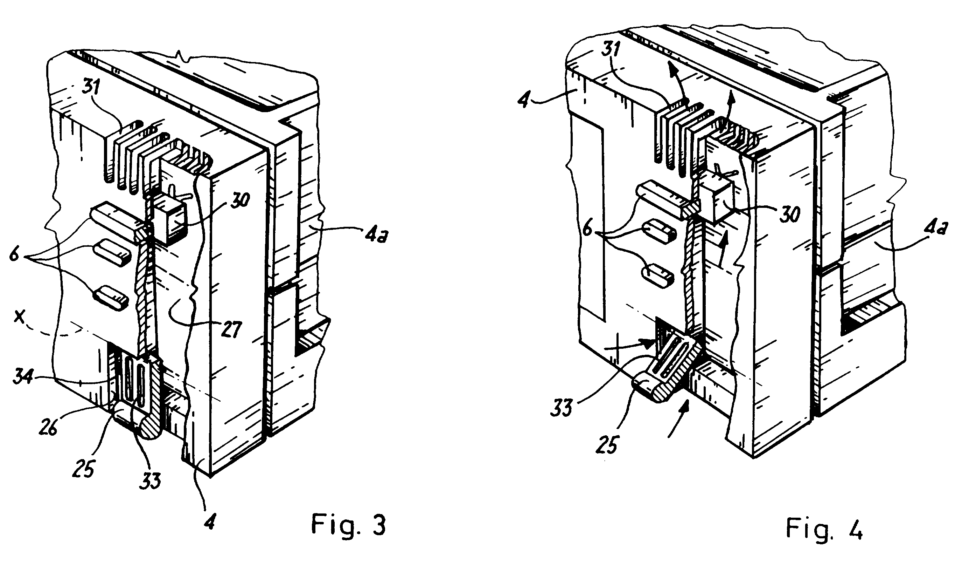

According to another characteristic of an embodiment of this invention, a tongue 25 (Figures 3, 4), which is mounted to swing in a cavity 26 in the front wall 4 at that end of the duct 27 which is opposite the grille 31, is provided for gripping and removing the body 2 from the box-shaped element 3. The tongue 25 is pivoted on the wall 4 about an axis X parallel to one of the sides of the wall 4 (Figure 3).

The tongue 25 swings about this axis between a non-operative state in which it is positioned in the cavity 26 and an operative state in which it projects from the front wall 4 to constitute an appendage for gripping the body 2.

When the tongue 25 is in the non-operative position, there is an opening 34 between the body 2 and the tongue itself which communicates with the duct 27. Air for ventilating the sensor 30 can thus flow through the opening 34 and the grille 31 and along the duct 27.

A false grille indicated 33 which harmonises with the grille 31 is also arranged on the tongue 25.

The invention thus solves the problem posed and brings many advantages. In particular, improved accessibility to all of the programming keys and an improved display of the parameters set are achieved.

## Claims

1. A device (1) for regulating the temperature, in particular of domestic surroundings comprising a body (2) which is removably inserted in a box-shaped element (3), at least one keyboard (9) which is used for programming the device and is mounted on the body (2), and retaining means (18a, b; 14a, b; 15a, b) between the body and the box-shaped element for holding the body in the box-shaped element in a removable manner, at least a display (5) indicating the temperature and the other operating parameters being accomodated on a front wall (4) of the body said front wall constituting a surface which is in view when the body is completely inserted in the box-shaped element, characterised in that the keyboard (9) is mounted on a wall (4c) of the body constituting a surface which is not in view when the body (2) is in the position in which it is completely inserted in the box-shaped element and which is accessible when the body (2) is partially removed from the box-shaped element (3).

2. A device according to Claim 1, wherein the keyboard (9) is provided on a sunken portion (7) of the wall (4c).

3. A device according to Claim 1 or 2, wherein the retaining means (18a, b; 14a, b; 15a, b) can be selectively switched between a first state in which the body (2) is held in the position in which it is completely inserted in the box-shaped element (3) and a second state in which the body (2) is held in a position in which it is partially removed with respect to the box-shaped element (3), in such a manner as to render the keyboard (9) accessible.

4. A device according to Claim 3, wherein the retaining means comprise at least one retaining member (18a, b) which extends along a side wall (4a, b) of the body (2), as well as a corresponding first and second seat (14a, b; 15a, b) arranged in the box-shaped element (3), the retaining member (18a, b) comprising a resilient rod (19a, b) connected at one end to the body (2) and carrying at the opposite, free end a tooth (20a, b) which is removably engaged in the first (14a, b) or second seat (15a, b) when the body (2) is in the first or second state, respectively.

5. A device according to Claim 4 wherein the first seat (14a, b) has an inclined surface (38a, b) for disengaging the corresponding tooth (20a, b) after stress has been applied to the body (2) to remove it from the position in which it is completely inserted in the box-shaped element (3).

6. A device according to Claim 1, comprising a control circuit part and a power circuit part (40) which are connected to one another electrically, the power circuit part (40) being mounted on the box-shaped element and being releasably connected to the control circuit part mounted in the body.

7. A device according to Claim 6, wherein the electrical connection is of the male/female type (42; 41).

8. A device according to one of claims 1 to 7 characterized in that it comprises a duct (27) which extends in the body for the ventilation of a sensor (30) measuring the ambient temperature, and means (25) for gripping the body (2) in order to remove it from the box-shaped element (3), said means comprising a tongue (25) which is mounted out of view on the body (2) and is movable between an operative position, in which it forms a gripping appendage of the body (2) for gripping and removing the same, and a non-operative position.

9. A device according to Claim 8, wherein the tongue (25) is associated with the body (2) in correspondence with one of the opposing ends of the duct (27), a first grille (31) which communicates with the outside being provided in correspondence with the other end.

10. A device according to Claim 8 or 9, wherein the tongue (25) is able to swing.

11. A device according to Claim 8, wherein an opening (34) communicating with the duct (27) for ventilating the sensor (30) is provided between the body (2) and the tongue (25) when the latter is in the non-operative position.

12. A device according to Claim 9, wherein the tongue (25) carries a second, false grille (33) which harmonises with the first grille (31).

## Patentansprüche

1. Vorrichtung zur Temperaturregelung (1), speziell für häusliche Umgebung, enhaltend ein Gehäuse (2), das lösbar in ein kastenförmiges Element (3) eingesetzt ist, wenigstens eine Tastatur (9), die zur Programmierung der Vorrichtung vorgesehen ist und die auf dem Gehäuse (2) angeordnet ist, und Rückhaltemittel (18 a, b; 14a, b; 15a, b) zwischen dem Gehäuse und dem kastenförmigen Element zum lösbaren Halten des Gehäuses in dem kastenförmigen Element, wenigstens eine Anzeige (5), die die Temperatur und andere Betriebsparameter anzeigt und an einer Vorderwand (4) des Gehäuses angeordnet ist, wobei die Vorderwand eine Oberfläche bildet, die sichtbar ist, wenn das Gehäuse vollständig in dem kastenförmigen Element eingesetzt ist, dadurch gekennzeichnet, daß die Tastatur (9) auf einer Wand (4 c) des Gehäuses angeordnet ist, wobei die Wand eine Oberfläche bildet, die nicht sichtbar ist, wenn das Gehäuse (2) vollständig in das kastenförmige Element eingesetzt ist, und die Tastatur zugänglich ist, wenn das Gehäuse (2) teilweise von dem kastenförmigen Element (3) entfernt ist.

2. Vorrichtung nach Anspruch 1, wobei die Tastatur (9) in einem vertieften Teil (7) der Wand (4 c) vorgesehen ist.

3. Vorrichtung nach Anspruch 1 oder 2, wobei die Rückhaltemittel (18a, b; 14a, b; 15a, b) wahlweise umschaltbar sind zwischen einem ersten Zustand, in dem das Gehäuse (2) in einer Position gehalten ist, in der es vollständig in dem kastenförmigen Element (3) eingesetzt ist und einem zweiten Zustand, in dem das Gehäuse (2) in einer Position gehalten ist, in der es teilweise von dem kastenförmigen Element (3) entfernt ist, so daß die Tastatur (9) zugänglich ist.

4. Vorrichtung nach Anspruch 3, wobei die Rückhaltemittel wenigstens ein Rückhalteglied (18 a,b) aufweisen, das sich entlang einer Seitenwand (4a, b) des Gehäuses (2) erstreckt, als auch eine entsprechende erste und zweite Aufnahme (14a, b; 15a, b) aufweisen, die in dem kastenförmigen Element (3) angeordnet sind und wobei das Rückhalteglied (18a, b) einen nachgiebigen Stab (19a, b) aufweist, der an einem Ende mit dem Gehäuse (2) verbunden ist und an dem gegenüberliegenden, freien Ende einen Zahn (20a, b) trägt, der lösbar mit der ersten (14 a, b) oder zweiten Aufnahme (15 a, b) in Eingriff bringbar ist, wenn das Gehäuse (2) jeweils in dem ersten oder zweiten Zustand ist.

5. Vorrichtung nach Anspruch 4, wobei die erste Aufnahme (14a, b) eine geneigte Fläche (38a, b) hat, damit der entsprechende Zahn (20a, b) lösbar ist, nachdem Kraft auf das Gehäuse (2) ausgeübt wurde, um es von der Position, in der es vollständig in das kastenförmige Element (3) eingesetzt ist, zu lösen.

6. Vorrichtung nach Anspruch 1, die ein Steuerschaltungsteil und ein Energieschaltungsteil (40) aufweist, die elektrisch miteinander verbunden sind, wobei das Energieschaltungsteil (40) auf dem kastenförmigen Element angeordnet ist und mit dem in dem Gehäuse angeordneten Steuerschaltungsteil lösbar verbindbar ist.

7. Vorrichtung nach Anspruch 6, wobei die elekrische Verbindung nach Art einer Stecker-/Buchsenverbindung (42; 41) ausgebildet ist.

8. Vorrichtung nach einem der Ansprüche 1-7, dadurch gekennzeichnet, daß sie eine Röhre (27) aufweist, die sich zur Lüftung eines die Umgebungstemperatur messenden Sensors (30) in dem Gehäuse erstreckt und daß die Vorrichtung Mittel (25) aufweist zum Ergreifen des Gehäuses (2), um es von dem kastenförmigen Element (3) zu entfernen, wobei diese Mittel eine Zunge (25) umfassen, die nicht sichtbar an dem Gehäuse (2) angebracht ist und die zwischen einer Arbeitsstellung, in der sie eine Handhabe für das Gehäuse (2) bildet zum Ergreifen und Entfernen desselben, und einer Ruhestellung bewegbar ist.

9. Vorrichtung nach Anspruch 8, wobei die Zunge (25) an einem der entgegengesetzten Enden der Röhre (27) mit dem Gehäuse (2) verbunden ist und ein erster rostartiger Grill (31) an dem anderem Ende vorgesehen ist, der mit der Umgebung in Verbindung steht.

10. Vorrichtung nach Anspruch 8 oder 9 wobei die Zunge (25) schwenkbar ist.

11. Vorrichtung nach Anspruch 8, wobei eine mit der Röhre (27) in Verbindung stehende Öffnung (34) zum Belüften des Sensors (30) zwischen dem Gehäuse (2) und der Zunge (25) vorgesehen ist, wenn die Zunge sich in der Ruhestellung befindet.

12. Vorrichtung nach Anspruch 9, wobei die Zunge (25) einen zweiten, unechten rostartigen Grill (33) trägt, der mit dem ersten Grill (31) übereinstimmt.

## Revendications

1. Appareil (1) de régulation de la température, en particulier dans des applications domestiques, comprenant un corps (2) qui est introduit de façon amovible dans un élément (3) en forme de caisson, au moins un clavier (9) utilisé pour la programmation de l'appareil et monté sur le corps (2), et un dispositif de retenue (18a, b ; 14a, b ; 15a, b) entre le corps et l'élément en forme de caisson destiné à retenir le corps dans l'élément en forme de caisson de manière amovible, au moins un dispositif d'affichage (5) indiquant la température et les autres paramètres de fonctionnement étant logé sur une paroi avant (4) du corps, la paroi avant constituant une surface qui est vue lorsque le corps est totalement introduit dans l'élément en forme de caisson, caractérisé en ce que le clavier (9) est monté sur une paroi (4c) du corps constituant une surface qui n'est pas vue lorsque le corps (2) est en position dans laquelle il est totalement introduit dans l'élément en forme de caisson et qui est accessible lorsque le corps (2) est retiré de l'élément en forme de caisson (3).

2. Appareil selon la revendication 1, dans lequel le clavier (9) est placé dans une partie (7) en creux de la paroi (4c).

3. Appareil selon la revendication 1 ou 2, dans lequel le dispositif de retenue (18a, b ; 14a, b ; 15a, b) peut être commuté sélectivement entre un premier état dans lequel le corps (2) est maintenu dans la position dans laquelle il est totalement introduit dans l'élément en forme de caisson (3), et un second état dans lequel le corps (2) est maintenu dans une position dans laquelle il est partiellement retiré de l'élément en forme de caisson (3) afin que le clavier (9) soit rendu accessible.

4. Appareil selon la revendication 3, dans lequel le dispositif de retenue comporte au moins un organe de retenue (18a, b) disposé le long d'une paroi latérale (4a, b) du corps (2), et un premier et un second siège correspondants (14a, b ; 15a, b) placés dans l'élément en forme de caisson (3), l'organe de retenue (18a, b) comprenant une tige élastique (19a, b) raccordée à une première extrémité au corps (2) et portant à l'extrémité libre opposée une dent (20a, b) qui coopère de façon amovible avec le premier (14a, b) ou le second (15a, b) siège lorsque le corps (2) est dans le premier ou le second état respectivement.

5. Appareil selon la revendication 4, dans lequel le premier siège (14a, b) a une surface inclinée (38a, b) destinée à séparer la dent correspondante (20a, b) après qu'une contrainte a été appliquée au corps (2) afin qu'il soit retiré de la position dans laquelle il est totalement introduit dans l'élément en forme de caisson (3).

6. Appareil selon la revendication 1, comprenant une partie de circuit de commande et une partie de circuit d'alimentation (40) qui sont connectées l'une à l'autre électriquement, la partie de circuit d'alimentation (40) étant montée sur l'élément en forme de caisson et étant raccordée temporairement à la partie de circuit de commande montée sur le corps.

7. Appareil selon la revendication 6, dans lequel la connexion électrique est du type mâle-femelle (42 ; 41).

8. Appareil selon l'une des revendications 1 à 7, caractérisé en ce qu'il comprend un conduit (27) pénétrant dans le corps pour la ventilation d'un capteur (30) de mesure de la température ambiante, et un dispositif (25) de saisie du corps (2) afin qu'il puisse être retiré de l'élément en forme de caisson (3), ce dispositif comprenant une languette (25) qui est montée sous forme cachée sur le corps (2) et qui est mobile entre une position de travail dans laquelle elle forme un accessoire de saisie du corps (2) permettant la saisie et l'extraction du corps, et une position de repos.

9. Appareil selon la revendication 8, dans lequel la languette (25) est associée au corps (2) d'une manière correspondant à l'une des extrémités opposées du conduit (27), une première grille (31) qui communique avec l'extérieur étant placée en position correspondant à l'autre extrémité.

10. Appareil selon la revendication 8 ou 9, dans lequel la languette (25) peut basculer.

11. Appareil selon la revendication 8, dans lequel une ouverture (34) communiquant avec le conduit (27) de ventilation du capteur (30) est placée entre le corps (2) et la languette (25) lorsque celle-ci n'est pas en position de travail.

12. Appareil selon la revendication 9, dans lequel la languette (25) porte une seconde fausse grille (33) qui s'harmonise avec la première grille (31).
